# EUROPÄISCHE PATENTANMELDUNG

(11) **EP 2 031 652 A2**
(43) Veröffentlichungstag der Anmeldung: **04.03.2009**
(21) Anmeldenummer: 08014187.2
(22) Anmeldetag: 12.08.2008
(51) Int. Cl.: H01L 21/74, H01L 21/84, H01L 27/12

(54) **Verfahren zur Herstellung einer Halbleiteranordnung, Verwendung und Halbleiteranordnung**

(30) Priorität: 31.08.2007 DE 102007041407
(71) Anmelder: ATMEL Germany GmbH, 74072 Heilbronn (DE)
(72) Erfinder: Schwantes, Stefan, Dr.-Ing., 22549 Hamburg (DE); Hoffmann, Thomas, Dipl.-Ing. (FH), 70469 Stuttgart (DE)
(74) Vertreter: Müller, Wolf-Christian

(57) **Zusammenfassung**

Verfahren zur Herstellung einer Halbleiteranordnung, Verwendung einer Grabenstruktur und Halbleiteranordnung mit einer monokristallinen Halbleiterschicht (100), mit einem leitfähigen Substratbereich (300) und mit einer vergrabenen Isolatorschicht (200, SOI), welche die monokristalline Halbleiterschicht (100) von dem leitfähigen Substratbereich (300) isoliert, wobei der leitfähige Substratbereich (300) kontaktiert wird, indem
- eine Grabenstruktur (901, 911, 901', 911') zur Trennung der monokristallinen Halbleiterschicht (100) in einen ersten Halbleiterbereich (102, 112) außerhalb der Grabenstruktur (901, 911, 901', 911') und einen zweiten Halbleiterbereich (101, 111) innerhalb der Grabenstruktur (901, 911, 901', 911') erzeugt wird,
- innerhalb des zweiten Halbleiterbereichs (101, 111) eine Öffnung (902, 912, 903, 913) in der monokristallinen Halbleiterschicht (100) erzeugt wird,
- innerhalb der Öffnung (902, 912) die vergrabene Isolatorschicht (200) entfernt wird, und
- in die Öffnung (902, 912, 903, 913) ein Leiter (700, 713) eingebracht wird, der den leitfähigen Substratbereich (300) kontaktiert und an den zweiten Halbleiterbereich (101, 111) grenzt.

## Beschreibung

Die vorliegende Erfindung betrifft ein Verfahren zur Herstellung einer Halbleiteranordnung, eine Verwendung einer Grabenstruktur und eine Halbleiteranordnung.

Für integrierte Schaltungen werden zunehmend Wafer mit einer vergrabenen Isolatorschicht verwendet. Derartige Wafer sind auch als SOI (engl. Silicon On Insulator) bekannt. Eine monokristalline Halbleiterschicht (beispielsweise Silizium) ist von einem Substrat durch die vergrabene Isolatorschicht getrennt. Dabei ist häufig gewünscht, dass das Substrat leitfähig ist und an ein gewünschtes Potential anschließbar ist. Hierzu kann das Substrat, also die Rückseite des Wafers, mit einer Metallschicht versehen und mittels Bonden mit einem Anschluss verbunden werden.

Alternativ ist es möglich, das Substrat von der Wafervorderseite her zu kontaktieren.

Der Erfindung liegt die Aufgabe zu Grunde, ein Verfahren, eine Verwendung oder eine Halbleitervorrichtung anzugeben, um den Herstellungsprozess möglichst zu vereinfachen.

Diese Aufgabe wird durch ein Verfahren mit den Merkmalen des unabhängigen Patentanspruchs 1 oder durch eine Verwendung mit den Merkmalen des unabhängigen Patentanspruchs 10 oder durch eine Halbleiteranordnung mit den Merkmalen des unabhängigen Patentanspruchs 11 gelöst. Vorteilhafte Weiterbildungen sind in der Beschreibung angegeben und sind Gegenstand von abhängigen Ansprüchen.

Demzufolge ist ein Verfahren zur Herstellung einer Halbleiteranordnung vorgesehen. Ausgangspunkt ist ein Wafer mit einer monokristallinen Halbleiterschicht, einem leitfähigen Substratbereich und einer vergrabenen Isolatorschicht. Derartige Wafer werden beispielsweise als SOI (Silicon On Insulator) bezeichnet. Jedoch kann für die Halbleiterschicht auch ein anderes Halbleitermaterial als Silizium, beispielsweise Germanium oder Gallium-Arsenid, verwendet werden. Als Isolatorschicht eignet sich jede isolierende Schicht, vorzugsweise Siliziumdioxid, jedoch kann beispielsweise auch Siliziumnitrid verwendet werden. Der leitfähige Substratbereich weist beispielsweise ein dotiertes Halbleitermaterial wie monokristallines oder polykristallines Silizium auf. Alternativ oder in Kombination kann der Substratbereich auch ein Metall, vorzugsweise Wolfram oder ein anderes Metall mit einem hohen Schmelzpunkt aufweisen.

Die Isolatorschicht ist zwischen der monokristallinen Halbleiterschicht und dem leitfähigen Substratbereich angeordnet, so dass die Isolatorschicht die monokristalline Halbleiterschicht von dem leitfähigen Substratbereich isoliert.

Ziel ist es, den leitfähigen Substratbereich von der Wafervorderseite aus zu kontaktieren.

Hierzu sind mehrere Verfahrensschritte vorgesehen. Eine Grabenstruktur wird zur Trennung der monokristallinen Halbleiterschicht in einen ersten Halbleiterbereich außerhalb der Grabenstruktur und einen zweiten Halbleiterbereich innerhalb der Grabenstruktur erzeugt. Eine Grabenstruktur kann beispielsweise einen tiefen Graben aufweisen. Ein tiefer Graben weist dabei eine größere Tiefe (in vertikaler Richtung) als Weite (in lateraler Richtung) auf. Hingegen weist ein flacher Graben eine größere Weite als Tiefe auf. Vorteilhafterweise wird ein Graben der Grabenstruktur erzeugt, indem ein tiefer Graben innerhalb eines flachen Grabens gebildet wird. Die Grabenstruktur kann weiterhin ein Dielektrikum zur Isolation aufweisen. Vorzugsweise wird durch die Grabenstruktur der erste Halbleiterbereich vom zweiten Halbleiterbereich in lateraler Richtung vollständig isoliert.

Innerhalb des zweiten Halbleiterbereichs wird eine Öffnung in der monokristallinen Halbleiterschicht erzeugt. Zur Erzeugung der Öffnung sind unterschiedliche Einzelprozesse anwendbar. Vorzugsweise wird das Halbleitermaterial entfernt. Beispielsweise kann das Halbleitermaterial geätzt werden. Möglichkeiten einer Ätzung sind eine nasschemische Ätzung und/oder bevorzugt eine Plasmaätzung (RIE - Reaktiv Ion Etching). Alternativ ist eine Laser-Ablation möglich. Die Öffnung reicht nach deren Erzeugung bis zur vergrabenen Isolatorschicht. Vorzugsweise erfolgt die Ätzung mit einem Ätzmittel, das für den Ätzvorgang eine höhere Selektivität für das Halbleitermaterial der Halbleiterschicht als für das Dielektrikum der Isolatorschicht aufweist, so dass der Ätzvorgang im Wesentlichen an einer Grenzfläche der Isolatorschicht stoppt.

Nachfolgend wird innerhalb der Öffnung die vergrabene Isolatorschicht entfernt. Bevorzugt erfolgt die Ätzung mit einem Ätzmittel, das für den Ätzvorgang eine höhere Selektivität für das Dielektrikum der Isolatorschicht als für das Halbleitermaterial der Halbleiterschicht und das Material des leitfähigen Substratbereichs aufweist, so dass der Ätzvorgang im Wesentlichen an einer Grenzfläche des Substratbereichs stoppt. Ebenfalls ist es möglich, dass teilweise in das Substrat geätzt wird. Wird ein Ätzmittel mit geringer Selektivität gegenüber dem Material des Substrates verwendet, wird der Ätzvorgang durch eine Zeitmessung begrenzt.

Nachfolgend wird in die Öffnung ein Leiter eingebracht, der den leitfähigen Substratbereich kontaktiert. Der Leiter kann dabei ein oder mehrere Materialien aufweisen. Vorzugsweise wird zur Einbringung des Leiters leitfähiges Material in der Öffnung abgeschieden. Als Material des Leiters wird vorzugsweise dotiertes polykristallines Halbleitermaterial eingebracht. Vorzugsweise wird polykristalline Halbleitermaterial in Doppelfunktion zugleich zur Ausbildung von Bauelementen (EEPROM, Kapazität, Widerstand) aufgebracht. Alternativ kann Wolfram gesputtert oder ein anderes Metall elektrolytisch abgeschieden werden. Ebenfalls ist es möglich eine Schicht, beispielsweise ein Halbleitermaterial durch einen Epitaxie-Prozess aufzubringen.

Nach dem Einbringen des Leiters grenzt der Leiter an den zweiten Halbleiterbereich. Bevorzugt ist der Leiter mit dem zweiten Halbleiterbereich an deren Grenzfläche leitend verbunden.

Die genannten Verfahrensschritte müssen dabei nicht unmittelbar aufeinander folgen. So können zwischen jeweiligen Verfahrensschritten, die einander nachfolgen, beispielsweise Reinigungsschritte vorgesehen sein.

Ein anderer Aspekt der Erfindung ist eine Verwendung einer Grabenstruktur zur Isolation einer Kontaktierungsstruktur in lateraler Richtung. In lateraler Richtung bedeutet dabei eine Richtung in der Waferoberfläche. Die Kontaktierungsstruktur ist zur Kontaktierung eines leitfähigen Substratbereichs ausgebildet. Hierzu weist die Kontaktierungsstruktur ein oder mehrere leitfähige Materialien auf.

Die verwendete Grabenstruktur umfasst einen monokristallinen Halbleiterbereich einer monokristallinen Halbleiterschicht. Die Umfassung ist vorzugsweise in jede laterale Richtung ausgebildet, so dass der monokristalline Halbleiterbereich von der Grabenstruktur umschlossen ist.

Die Grabenstruktur grenzt an eine vergrabene Isolatorschicht, welche die monokristalline Halbleiterschicht außerhalb des monokristallinen Halbleiterbereichs vom leitfähigen Substratbereich in vertikaler Richtung isoliert. In vertikaler Richtung bedeutet dabei eine Richtung senkrecht zur Waferoberfläche.

Ein Leiter der Kontaktierungsstruktur ist innerhalb einer Öffnung in dem monokristallinen Halbleiterbereich ausgebildet. Der Leiter verbindet den leitfähigen Substratbereich mit dem monokristallinen Halbleiterbereich elektrisch leitend.

Ein anderer Aspekt der Erfindung ist eine Halbleiteranordnung. Die Halbleiteranordnung weist einen ersten Halbleiterbereich und einen zweiten Halbleiterbereich einer monokristallinen Halbleiterschicht auf. Weiterhin weist die Halbleiteranordnung zumindest einen leitfähigen Substratbereich auf. Es können auch mehrere leitfähige Substratbereiche ausgebildet sein, die beispielsweise voneinander durch ein Dielektrikum isoliert sind.

Weiterhin weist die Halbleiteranordnung eine vergrabene Isolatorschicht (SOI) auf, welche den ersten Halbleiterbereich der monokristallinen Halbleiterschicht von dem leitfähigen Substratbereich isoliert. Die Isolatorschicht ist dabei zwischen dem ersten Halbleiterbereich und dem leitfähigen Substrat ausgebildet.

Weiterhin weist die Halbleiteranordnung eine Grabenstruktur auf, die den ersten Halbleiterbereich der monokristallinen Halbleiterschicht von dem zweiten Halbleiterbereich der monokristallinen Halbleiterschicht trennt.

Weiterhin weist die Halbleiteranordnung eine Kontaktierungsstruktur auf. Die Kontaktierungsstruktur weist einen Leiter auf, der innerhalb einer bis zum Substratbereich reichenden Öffnung im zweiten Halbleiterbereich angeordnet ist. Der Leiter grenzt sowohl an den Substratbereich als auch an den zweiten Halbleiterbereich.

Gemäß einer vorteilhaften Weiterbildung wird die Grabenstruktur als geschlossene Struktur ausgebildet. Vorzugsweise weist die Grabenstruktur dabei zumindest einen Graben mit gradlinigen und/oder gebogenen Abschnitten aus. Vorteilhafterweise ist die Grabenstruktur als geschlossene Ringstruktur, geschlossene Stadionstruktur oder geschlossene Rechteckstruktur ausgebildet. Bevorzugt grenzt zumindest ein Graben der Grabenstruktur an die vergrabene Isolatorschicht. Bevorzugt ist durch die geschlossene Grabenstruktur der zweite Halbleiterbereich in lateraler Richtung vollständig isoliert. Hierdurch wird bewirkt, dass der zweite Halbleiterbereich durch Dielektrikum umfasst ist. Es verbleibt jedoch eine Öffnung in der vergrabenen Isolatorschicht zur Kontaktierung des leitfähigen Substratbereiches.

In einer vorteilhaften Weiterbildung ist vorgesehen, dass in den zumindest einen Graben ein Dielektrikum zur Isolation - wie beispielsweise Siliziumdioxid - eingebracht ist. Zusätzlich können weitere Materialien den Graben verfüllen. Vorzugsweise wird die Grabenstruktur mit einem Dielektrium insbesondere zur lateralen Isolierung zwischen dem ersten Halbleiterbereich und des zweiten Halbleiterbereich zumindest teilweise verfüllt. Hierzu kann beispielsweise auf den Wandungen der Grabenstruktur Siliziumdioxid oder Siliziumnitrid abgeschieden werden.

Zwar ist es prinzipiell möglich, dass die Öffnung an die Grabenstruktur angrenzt, gemäß einer vorteilhaften Weiterbildung der Erfindung wird jedoch die Öffnung durch eine entsprechende Maskierung von der Grabenstruktur beabstandet angeordnet. Vorzugsweise ist die Öffnung innerhalb des zweiten Halbleiterbereichs zur geschlossenen Grabenstruktur im Zentrumsbereich angeordnet. Die Möglichkeiten der Zentrierung sind dabei von den Genauigkeiten des Produktionsprozesses abhängig. In Abhängigkeit von diesen Genauigkeiten wird vorzugsweise die Größe des zweiten Halbleiterbereichs festgelegt.

In einer besonders vorteilhaften Weiterbildung wird die Öffnung zusammen mit der Grabenstruktur in einem Ätzschritt oder mehreren Ätzschritten gleichzeitig erzeugt. Vorzugsweise ist eine einzige Maske zur Maskierung der Grabenstruktur und der Öffnung vorgesehen.

Gemäß einer Ausgestaltung dient die Öffnung als Maskierung, wenn die vergrabene Isolatorschicht innerhalb der Öffnung entfernt wird. Dabei muss sichergestellt sein, dass die Grabenstruktur durch eine Maskierung abgedeckt ist. Vorzugsweise wird dabei die vergrabene Isolatorschicht innerhalb der Grabenstruktur durch diese Maskierung vor einem Ätzangriff geschützt.

Bevorzugt ist vorgesehen, dass der zweite Substratbereich derart mit einem Metallkontakt kontaktiert wird, dass der zweite Substratbereich den Metallkontakt mit dem Leiter elektrisch leitend verbindet. Zur Kontaktierung mit dem Metallkontakt wird vorzugsweise an der Grenzfläche zwischen dem zweiten Substratbereich und dem Metallkontakt in den zweiten Substratbereich Dotanden eingebracht. Vorzugsweise ist die Dotierstoffkonzentration an der Grenzfläche derart hoch, dass sich ein Ohmscher Kontakt ausbildet.

Gemäß unterschiedlicher Ausgestaltungsvarianten weist der Leiter polykristallines Halbleitermaterial oder ein Metall oder eine Kombination aus Halbleitermaterial und Metall auf. Vorzugsweise weist das Metall eine hohe Schmelztemperatur - wie beispielsweise bei Wolfram - auf.

In einer Ausgestaltung ist vorgesehen, dass im ersten Halbleiterbereich zumindest ein aktives Bauelement, insbesondere ein Transistor ausgebildet ist. Vorzugsweise ist das aktive Bauelement derart ausgebildet, dass zumindest eine elektrische Eigenschaft, wie eine Durchbruchspannung vom Potential des leitfähigen Substratbereichs abhängig ist. Ein derartiges Bauelement ist beispielsweise ein DMOS-Feldeffekttransistor, wobei der leitfähige Substratbereich als Rückseitenelektrode wirkt.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung des Ausführungsbeispiels der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen
- Fig. 1: eine schematische Schnittansicht durch einen Wafer,
- Figuren 2a bis 2g: schematische Schnittansichten durch einen Wafer zu unterschiedlichen Zeitpunkten im Herstellungsprozess eines ersten Ausführungsbeispiels, und
- Figuren 3a bis 3g: schematische Schnittansichten durch einen Wafer zu unterschiedlichen Zeitpunkten im Herstellungsprozess eines zweiten Ausführungsbeispiels.

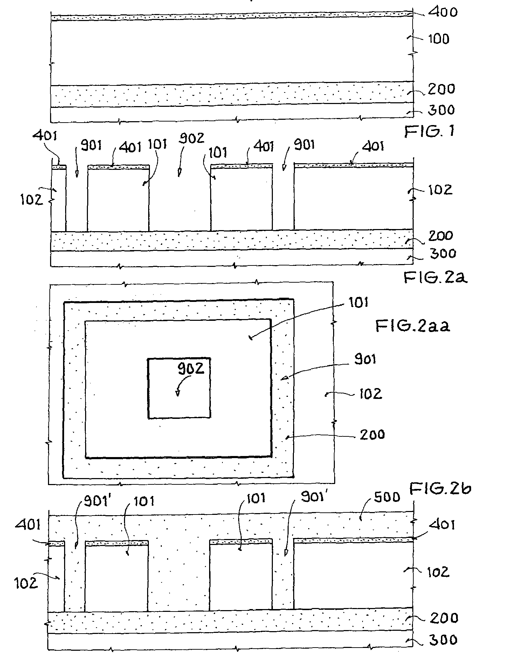

In Fig. 1 ist eine Schnittansicht durch einen Wafer im Ausgangszustand schematisch dargestellt. Auf einem einzigen Substratbereich 300 ist eine vergrabene Isolatorschicht 200 angeordnet. Oberhalb der Isolatorschicht 200 ist eine monokristalline Halbleiterschicht 100 angeordnet. Oberhalb der monokristallinen Halbleiterschicht 100 ist eine Oxidschicht 400 ausgebildet. Beispielsweise besteht in den beiden folgend beschriebenen Ausgestaltungsvarianten der Substratbereich 300 aus Silizium, die vergrabene Isolatorschicht 200 aus Siliziumdioxid und die monokristalline Halbleiterschicht 100 aus Silizium. Die genannten Materialien sind zwar vorteilhaft, können aber auch durch andere in der Halbleiterproduktion bekannte Materialien ersetzt werden.

In der ersten Ausführungsvariante, die in den Figuren 2a bis 2g schematisch gezeigt wird, wird zunächst die Oxidschicht 400 als 50nm dicke Oxidhartmaske 401 strukturiert (in Fig. 2a nicht dargestellt). Nachfolgend erfolgt eine Grabenätzung mittels der Oxidhartmaske 401 mit zwei verschiedenen Weiten. Der Graben 901 einer Grabenstruktur weist eine Weite von 800nm auf. Hingegen wird zeitgleich eine Öffnung 902 geätzt, die eine Weite von 2000nm aufweist. Die Öffnung 902 dient später der Kontaktierung des Substratbereichs 300. Der schmalere Graben 901 ist ein Standardgraben im Herstellungsprozess und dient später der lateralen Isolierung des Kontakts.

Durch den Standardgraben 901 wird die monokristalline Halbleiterschicht 100 (siehe Fig. 1) in einen ersten monokristallinen Halbleiterbereich 102 und in einen zweiten monokristallinen Halbleiterbereich 101 getrennt. Der Graben 901 ist dabei als geschlossene Struktur um die Öffnung 902 ausgebildet, wie dies aus der Fig. 2aa ersichtlich ist. Dabei ist in Fig. 2aa die Oxidhartmaske 401 nicht dargestellt.

In Fig. 2b sind der Graben 901 und die Öffnung 902 mit einem Dielektrikum 500 verfüllt worden. Das Dielektrikum 500 ist beispielsweise eine 1100 nm dicke TEOS Füllung. Die Grabenstruktur 901' weist demzufolge nun eine Dielektrikumfüllung auf.

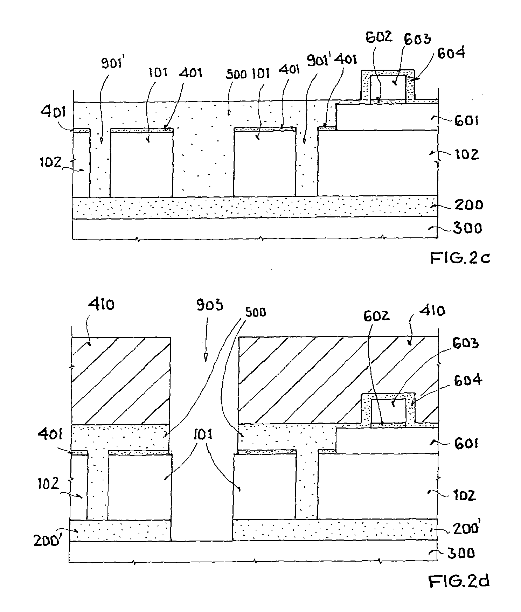

In der Fig. 2c ist der Verfahrensstand nach der Erzeugung eines CMOS-Bauelements schematisch dargestellt. Durch Epitaxie ist zuvor das monokristalline Halbleitergebiet 601 mit einer gewünschten Dotierstoffkonzentration erzeugt worden. Auf dem Halbleitergebiet 601 ist ein Gateoxid 602 und eine Gateelektrode 603 aus polykristallinem Silizium erzeugt worden. Die Gateelektrode 603 ist durch eine Oxidschicht 604 abgedeckt.

Zur Erzeugung einer bis zum Substratbereich 300 durchgehenden Öffnung 903 wird zunächst eine Maskierung 410 durch Aufbringen eines Photolacks und anschließender photolithographischer Strukturierung erzeugt, wie die in Fig. 2d dargestellt ist. Alternativ kann die Maskierung auch durch eine so genannte Hartmaske erzielt werden (in Fig. 2d nicht dargestellt). Beispielsweise wird Siliziumnitrid abgeschieden und mittels Lackmaske strukturiert. Die Lackmaske wird wieder entfernt und die verbleibende Hartmaske aus Siliziumnitrid dient in der nachfolgenden Ätzung als schützende Abdeckschicht.

Anschließend wird das Dielektrikum 500 im Bereich der Öffnung 903 durch Ätzen entfernt. Die Ätzung stoppt dabei auf dem Substratbereich 300 aufgrund der höheren Selektivität des Ätzmittels für das Dielektrikum 500. Dabei wird auch die Öffnung 903 durch die vergrabene Isolatorschicht 200' geätzt, die hierdurch im Bereich der gewünschten Kontaktierung geöffnet wird.

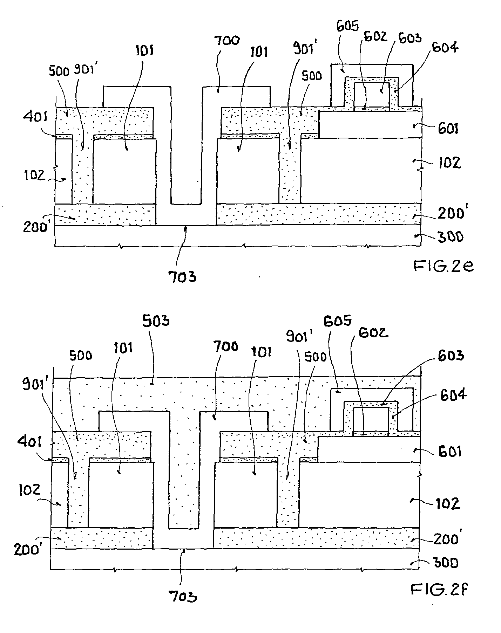

In dem im ersten Ausführungsbeispiel verwendeten Herstellungsprozess wird eine zweite polykristalline Halbleiterschicht erzeugt, die nachfolgend strukturiert wird. Die zweite polykristalline Halbleiterschicht wird in demselben Herstellungsprozess vorteilhafterweise in Doppelfunktion für Bauelemente verwendet um beispielsweise einen Widerstand, eine Kapazität oder eine EEPROM-Zelle zu erzeugen. In Fig. 2e ist schematisch dargestellt, dass das polykristalline Halbleitergebiet 605 zusammen mit der Gateelektrode 603 und der Oxidschicht 604 eine Kapazität ausbildet.

Die vorherige Öffnung 903 wird mit dem zweiten Polysilizium gefüllt, das dotiert und strukturiert den Leiter 700 ausbildet. Das Polysilizium weist dabei eine Dicke von 400 nm auf. Der Leiter 700 grenzt an der Grenzfläche 703 an den Substratbereich 300 an und ist ein Teil der Kontaktierungsstruktur zur Kontaktierung des Substratbereichs 300. Zugleich grenzt der Leiter 700 auch an den zweiten monokristallinen Halbleiterbereich 101 und verbindet den zweiten monokristallinen Halbleiterbereich 101 mit dem Substratbereich 300 leitend. Der Leiter 700 ist in lateraler Richtung durch den gefüllten Graben 901' der Grabenstruktur isoliert. Hierdurch ist vorteilhafterweise gewährleistet, dass das Substratpotential des Substratbereichs 300 unabhängig von einem Potential im ersten Halbleiterbereich 102 und damit im Halbleitergebiet 601 des CMOS-Transistors einstellbar ist.

Aufgrund der örtlichen Trennung des Leiters 700 und der Isolation durch den gefüllten Graben 901' können beide hinsichtlich ihrer Funktion getrennt optimiert werden, ohne einen signifikant höheren Platzbedarf in der Waferoberfläche zu benötigen. Der Graben 901' der Grabenstruktur ist dabei hinsichtlich der Störstellen im angrenzenden ersten monokristallinen Halbleiterbereich 102 optimiert. Hingegen muss die Öffnung 903 für den Leiter 700 hinsichtlich einer sicheren und zuverlässigen Kontaktierung des Substratbereichs 300 hin optimiert sein. Dies wird durch die Funktionstrennung gemäß dem Ausführungsbeispiel der Figuren 2a bis 2g auf vorteilhafte Weise erzielt.

Nachfolgend wird, wie in Fig. 2f schematisch dargestellt ein Dielektrium 503 zur Isolation abgeschieden. Das Dielektrikum 503 ist beispielsweise TEOS.

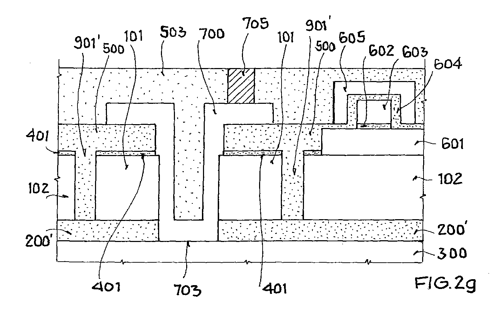

Gemäß Fig. 2g wird nachfolgend eine Standardkontaktätzung und Füllung zur Herstellung eines Metallkontaktes 705 durchgeführt, um das zweite Polysilizium zu kontaktieren. An der Stelle des Leiters 700 wird der Metallkontakt 705 zur Ausbildung eines Anschlusses für den Substratbereich 300 eingebracht und ist ein Teil der Kontaktierungsstruktur. Das Metall des Metallkontaktes 705 ist beispielsweise Wolfram.

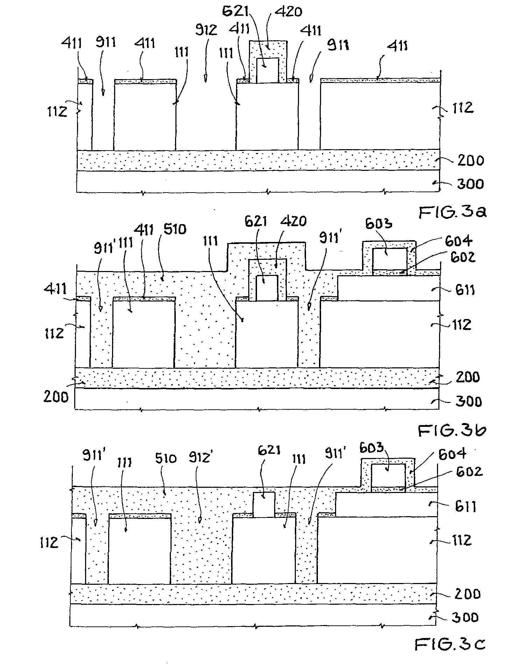

In der zweiten Ausführungsvariante, die in den Figuren 3a bis 3g schematisch gezeigt wird, wird zunächst die Oxidschicht 400 als 50nm dicke Oxidhartmaske 411 strukturiert (in Fig. 2a nicht dargestellt). Nachfolgend erfolgt eine Grabenätzung mittels der Oxidhartmaske 411 mit zwei verschiedenen Weiten. Der Graben 911 einer Grabenstruktur weist eine Weite von 800nm auf. Hingegen wird zeitgleich eine Öffnung 912 geätzt, die eine Weite von 2000nm aufweist. Die Öffnung 912 dient später der Kontaktierung des Substratbereichs 300. Der schmalere Graben 911 ist ein Standardgraben im Herstellungsprozess und dient später der lateralen Isolierung des Kontakts. Der Graben 911 wird erzeugt, indem ein tiefer Graben (engl. deep trench) aus einem flachen Graben (STI) heraus geätzt wird (in Fig. 3a nicht dargestellt). An den flachen Graben (STI) angrenzend können Bauelemente ausgebildet werden, wobei außerhalb des flachen Grabens (STI) eine geringere Störstellenkonzentration an der Halbleiteroberfläche auftritt.

Durch den Standardgraben 911 wird die monokristalline Halbleiterschicht 100 (siehe Fig. 1) in einen ersten monokristallinen Halbleiterbereich 112 und in einen zweiten monokristallinen Halbleiterbereich 111 getrennt. Beide monokristallinen Halbleiterbereiche weisen beispielsweise eine Dotierstoffkonzentration größer 1e16cm⁻³ auf. Der Graben 911 ist als geschlossene Struktur um die Öffnung 912 ausgebildet.

In Fig. 3b sind der Graben 911 und die Öffnung 912 mit einem Dielektrikum 510 verfüllt worden. Das Dielektrikum 510 ist beispielsweise eine 1100 nm dicke TEOS Füllung. Die Grabenstruktur 911' weist demzufolge nun eine Dielektrikumfüllung auf.

In der Fig. 3c ist der Verfahrensstand nach der Erzeugung eines CMOS-Bauelements schematisch dargestellt. Durch Epitaxie sind zuvor die monokristallinen Halbleitergebiete 621 und 611 mit einer gewünschten Dotierstoffkonzentration erzeugt worden. Auf dem Halbleitergebiet 611 ist ein Gateoxid 602 und eine Gateelektrode 603 aus polykristallinem Silizium erzeugt worden. Die Gateelektrode 603 ist durch eine Oxidschicht 604 abgedeckt. Gemäß den Figuren 3a und 3b wird vor der Ätzung des Grabens 911 und der Öffnung 912 eine Hartmaske 420 beispielsweise aus Siliziumnitrid auf das monokristalline Halbleitergebiet 621 aufgebracht, um das monokristalline Halbleitergebiet 621 vor dem Ätzangriff zu schützen. Die Hartmaske wird vor dem Erzeugen des Gateoxids 602 entfernt.

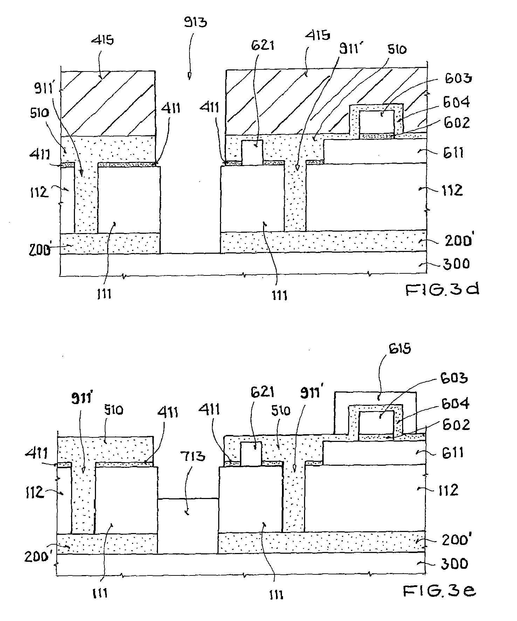

Zur Erzeugung einer bis zum Substratbereich 300 durchgehenden Öffnung 913 wird zunächst eine Maskierung 415 durch Aufbringen eines Photolacks und anschließender photolithographischer Strukturierung erzeugt, wie diese in Fig. 3d dargestellt ist. Anschließend wird das Dielektrikum 510 im Bereich der Öffnung 913 durch Ätzen entfernt. Die Ätzung stoppt dabei auf dem Substratbereich 300 aufgrund der höheren Selektivität des Ätzmittels für das Dielektrikum 510. Dabei wird auch die Öffnung 913 durch die vergrabene Isolatorschicht 200' geätzt, die hierdurch im Bereich der gewünschten Kontaktierung geöffnet wird.

In den im zweiten Ausführungsbeispiel verwendeten Herstellungsprozess wird eine zweite polykristalline Halbleiterschicht (400 nm) erzeugt, die nachfolgend strukturiert wird. Die zweite polykristalline Halbleiterschicht wird in demselben Herstellungsprozess vorteilhafterweise in Doppelfunktion für Bauelemente verwendet, um beispielsweise einen Widerstand, eine Kapazität oder eine EEPROM-Zelle zu erzeugen. In Fig. 3e ist schematisch dargestellt, dass das polykristalline Halbleitergebiet 615 zusammen mir der Gateelektrode 603 und der Oxidschicht 604 eine Kapazität ausbildet.

Die vorherige Öffnung 913 wird mit dem zweiten Polysilizium gefüllt, das dotiert und strukturiert den Leiter 713 ausbildet. Der Leiter 713 grenzt an der Grenzfläche an den Substratbereich 300 an und ist ein Teil der Kontaktierungsstruktur zur Kontaktierung des Substratbereichs 300. Der Graben wird bei der Strukturierung der zweiten Polysiliziumschicht nicht durch eine Maskierung abgedeckt. Daher wird ein großer Teil des Polysiliziums aus der Öffnung 913 wieder herausgeätzt. Ein Leiter 713 bleibt jedoch vorhanden, der sowohl an den Substratbereich 300 als auch an den zweiten Halbleiterbereich 111 grenzt und beide miteinander elektrisch leitend verbindet.

Der Leiter 713 ist in lateraler Richtung durch den gefüllten Graben 911' der Grabenstruktur isoliert. Hierdurch ist vorteilhafterweise gewährleistet, dass das Substratpotential des Substratbereichs 300 unabhängig von einem Potential im ersten Halbleiterbereich 112 und damit im Halbleitergebiet 611 des CMOS-Transistors einstellbar ist. Aufgrund der örtlichen Trennung des Leiters 713 und der Isolation durch den gefüllten Graben 911' wird der überraschende Effekt erzielt, dass beide hinsichtlich ihrer Funktion getrennt optimiert werden können, ohne einen signifikant höheren Platzbedarf in der Waferoberfläche zu benötigen. Der Graben 911' der Grabenstruktur ist dabei hinsichtlich der Störstellen im angrenzenden ersten monokristallinen Halbleiterbereich 112 durch Ausbildung der flachen Gräben (STI) optimiert. Hingegen muss die Öffnung 913 für den Leiter 713 hinsichtlich einer sicheren und zuverlässigen Kontaktierung des Substratbereichs 300 hin optimiert sein.

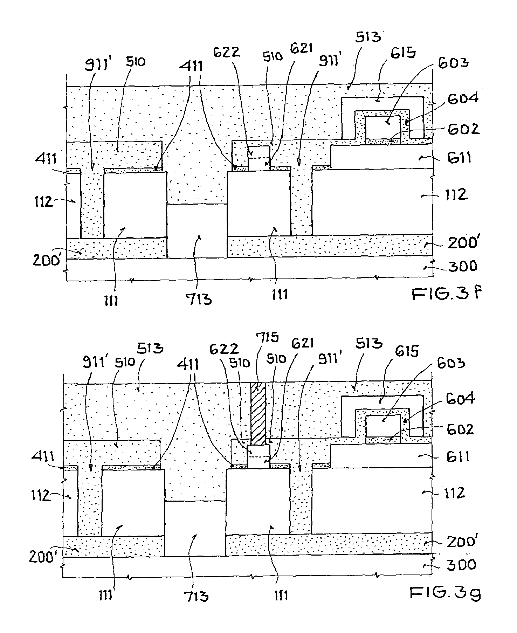

Hierzu wird, wie in Fig. 3f schematisch dargestellt das Halbleitergebiet 621 zumindest in dem Bereich 422 hoch dotiert. Dieser grenzt unmittelbar an den Bereich 421, der eine elektrisch leitende Verbindung zum zweiten Halbleiterbereich 111 bewirkt. Die hohe Dotierstoffkonzentration wird vorteilhafterweise synergetisch mit einer Implantation für die Source- oder Draingebiete (in Fig. 3f nicht dargestellt) des CMOS-Transistors erzeugt.

Weiterhin wird ein Dielektrium 513 zur Isolation abgeschieden. Das Dielektrikum 513 ist beispielsweise TEOS.

Gemäß Fig. 3g wird nachfolgend eine Standardkontaktätzung und Füllung zur Herstellung eines Metallkontaktes 715 durchgeführt, um den hochdotierten Bereich 422 zu kontaktieren. Der hochdotierte Bereich 422 ermöglicht dabei einen Ohmschen Anschluss an den Metallkontakt 715. An der Stelle des hoch dotierten Bereichs 422 wird der Metallkontakt 715 zur Ausbildung eines Anschlusses für den Substratbereich 300 eingebracht und ist ein Teil der Kontaktierungsstruktur. Das Metall des Metallkontaktes 715 ist beispielsweise Wolfram.

Gegenüber den Ausführungsbeispiel der Figuren 2a bis 2g weist das Ausführungsbeispiel der Figuren 3a bis 3g mehrere Vorteile auf. Der Metallkontakt 715 und der hoch dotierte Bereich 422 ermöglichen einen besonders niederohmigen Kontakt auf üblicher Höhe der Kontaktierung für die Transistoren erfordert also lediglich die bereits vorhandene Kontaktierung zu nutzen. Eine Kantenüberlappung oberhalb des zweiten Halbleiterbereichs durch das zweite Polysilizium ist nicht erforderlich und daher auch nicht prozesskritisch.

Ein besonderer Vorteil beide Ausführungsvarianten ist, dass für den Standardprozess mit zwei Polysiliziumschichten lediglich eine einzige weitere Maske und ein einziger Oxidätzschritt zusätzlich zum Standardprozess benötigt werden, um eine Kontaktierung des Substratbereichs auszubilden.

Die Erfindung ist dabei nicht auf die dargestellten Ausführungsbeispiele beschränkt. Anstelle des zweiten Polysiliziums kann beispielsweise auch ein Metall, beispielsweise Wolfram als Leiter verwendet werden. Auch lassen sich andere Halbleiter, wie beispielsweise Silizium-Germanium verwenden. Auch ist es möglich keinen flachen Graben (STI) zu erzeugen, sondern zur Erzeugung der Öffnung für die Kontaktierung des Substratbereichs und zur Ausbildung der Grabenstruktur ausschließlich tiefe Gräben zu ätzen.

Die Funktionalität der Halbleiteranordnung der Figuren 2g oder 3g kann besonders vorteilhaft für einen Schaltkreis eines Smart-Power-Systems insbesondere mit integrierten DMOS-Transistoren verwendet werden.

### Bezugszeichenliste

- 100: monokristalline Halbleiterschicht, c-Si
- 101, 111: zweiter Halbleiterbereich
- 102, 112: erster Halbleiterbereich
- 200, 200': vergrabene Isolatorschicht, SiO₂
- 300: leitfähiger Substratbereich, Si
- 400: Oxidschicht
- 401, 411: Oxidhartmaske
- 410, 415: photolithographisch strukturierter Resist
- 420: Hartmaske für das Aktivgebiet
- 422: hochdotierter Bereich
- 421: dotierter Bereich
- 500, 503, 510, 513: Dielektrikum, TEOS
- 601: monokristalliner aufgewachsen HL
- 602: Gateoxid
- 603: Gateelektrode, polykristallines Halbleitermaterial, poly-Si
- 604: Oxid
- 605, 615: polykristallines Halbleitermaterial, poly-Si
- 611, 621: epitaktisch erzeugtes Halbleitergebiet
- 700, 713: Leiter, poly-Si, Wolfram
- 703: Grenzfläche zwischen Leiter und leitfähigem Substratbereich
- 705, 715: Metallkontakt
- 901, 911: Grabenstruktur, Graben
- 901', 911': Grabenstruktur, mit Dielektrikum verfüllter Graben
- 902, 912, 903, 913: Öffnung

## Patentansprüche

1. Verfahren zur Herstellung einer Halbleiteranordnung mit einer monokristallinen Halbleiterschicht (100), mit einem leitfähigen Substratbereich (300) und mit einer vergrabenen Isolatorschicht (200, SOI), welche die monokristalline Halbleiterschicht (100) von dem leitfähigen Substratbereich (300) isoliert, wobei der leitfähige Substratbereich (300) kontaktiert wird, indem
- eine Grabenstruktur (901, 911, 901', 911') zur Trennung der monokristallinen Halbleiterschicht (100) in einen ersten Halbleiterbereich (102, 112) außerhalb der Grabenstruktur (901, 911, 901', 911') und einen zweiten Halbleiterbereich (101, 111) innerhalb der Grabenstruktur (901, 911, 901', 911') erzeugt wird,
- innerhalb des zweiten Halbleiterbereichs (101, 111) eine Öffnung (902, 912, 903, 913) in der monokristallinen Halbleiterschicht (100) erzeugt wird,
- innerhalb der Öffnung (902, 912) die vergrabene Isolatorschicht (200) entfernt wird, und
- in die Öffnung (902, 912, 903, 913) ein Leiter (700, 713) eingebracht wird, der den leitfähigen Substratbereich (300) kontaktiert und an den zweiten Halbleiterbereich (101, 111) grenzt.

2. Verfahren nach Anspruch 1, bei dem die Grabenstruktur (901, 911, 901', 911') als geschlossene Struktur ausgebildet wird.

3. Verfahren nach einem der vorhergehenden Ansprüche, bei dem die Grabenstruktur (901, 911, 901', 911') mit einem Dielektrium (500, 510) insbesondere zur lateralen Isolierung zwischen dem ersten Halbleiterbereich (102, 112) und des zweiten Halbleiterbereich (101, 111) zumindest teilweise verfüllt wird.

4. Verfahren nach einem der vorhergehenden Ansprüche, bei dem die Grabenstruktur (901, 911, 901', 911') an die vergrabene Isolatorschicht (200, 200') grenzt.

5. Verfahren nach einem der vorhergehenden Ansprüche, bei dem die Öffnung (902, 912, 903, 913) von der Grabenstruktur (901, 911, 901', 911') beabstandet angeordnet wird.

6. Verfahren nach einem der vorhergehenden Ansprüche, bei dem die Öffnung (902, 912, 903, 913) zusammen mit der Grabenstruktur (901, 911, 901', 911') in einem Ätzschritt erzeugt wird.

7. Verfahren nach einem der vorhergehenden Ansprüche, bei dem die Öffnung (902, 912, 903, 913) als Maskierung während des Entfernens der vergrabenen Isolatorschicht (200, 200') innerhalb der Öffnung (902, 912, 903, 913) dient.

8. Verfahren nach Anspruch 7, bei dem die Grabenstruktur (901, 911, 901', 911') während des Entfernens der vergrabenen Isolatorschicht (200, 200') innerhalb der Öffnung (902, 912, 903, 913) abgedeckt wird.

9. Verfahren nach einem der vorhergehenden Ansprüche, bei dem der zweite Halbleiterbereich (111) derart mit einem Metallkontakt (715) kontaktiert wird, dass der zweite Substratbereich (111) den Metallkontakt (715) mit dem Leiter (713) elektrisch leitend verbindet.

10. Verwendung einer Grabenstruktur (901, 911, 901', 911') zur lateralen Isolation einer Kontaktierungsstruktur zur Kontaktierung eines leitfähigen Substratbereichs (300),
- bei der die Grabenstruktur (901, 911, 901', 911') einen monokristallinen Halbleiterbereich (102, 112) einer monokristallinen Halbleiterschicht (100) umschließt,
- bei der die Grabenstruktur (901, 911, 901', 911') an eine vergrabene Isolatorschicht (200, 200') grenzt, welche die monokristalline Halbleiterschicht (100) außerhalb des monokristallinen Halbleiterbereichs (102, 112) vom leitfähigen Substratbereich (300) in vertikaler Richtung isoliert, und
- bei der ein Leiter (700, 713) der Kontaktierungsstruktur innerhalb einer Öffnung (902, 912, 903, 913) in dem monokristallinen Halbleiterbereich (102, 112) ausgebildet ist und den leitfähigen Substratbereich (300) mit dem monokristallinen Halbleiterbereich (102, 112) leitend verbindet.

11. Halbleiteranordnung
- mit einem ersten Halbleiterbereich (102, 112) einer monokristallinen Halbleiterschicht (100),
- mit einem zweiten Halbleiterbereich (102, 111) der monokristallinen Halbleiterschicht (100),
- mit einem leitfähigen Substratbereich (300),
- mit einer vergrabenen Isolatorschicht (200, 200', SOI), welche den ersten Halbleiterbereich (102, 112) der monokristallinen Halbleiterschicht (100) von dem leitfähigen Substratbereich (300) isoliert,
- mit einer Grabenstruktur (901, 911, 901', 911'), die den ersten Halbleiterbereich (102, 112) der monokristallinen Halbleiterschicht (100) von dem zweiten Halbleiterbereich (101, 111) der monokristallinen Halbleiterschicht (100) trennt,
- mit einer Kontaktierungsstruktur, die einen Leiter (700, 713) aufweist, der innerhalb einer bis zum Substratbereich (300) reichenden Öffnung (902, 912, 903, 913) im zweiten Halbleiterbereich (101, 111) angeordnet ist und an den Substratbereich (300) und an den zweiten Halbleiterbereich (101, 111) grenzt.

12. Halbleiteranordnung nach Anspruch 11, bei der die Grabenstruktur (901, 911, 901', 911') an die vergrabene Isolatorschicht (200, 200') grenzt.

13. Halbleiteranordnung nach einem der Ansprüche 11 oder 12 , bei der die Grabenstruktur (901, 911, 901', 911') eine geschlossene Struktur ist.

14. Halbleiteranordnung nach einem der Ansprüche 11 bis 13, bei der der Leiter (700, 713) polykristallines Halbleitermaterial aufweist.

15. Halbleiteranordnung nach einem der Ansprüche 11 bis 14, bei der der Leiter (700, 713) ein Metall aufweist.

16. Halbleiteranordnung nach einem der Ansprüche 11 bis 15, bei der im ersten Halbleiterbereich (102, 112) zumindest ein aktives Bauelement, insbesondere ein Transistor ausgebildet ist.

17. Halbleiteranordnung nach einem der Ansprüche 11 bis 16, bei der der zweite Substratbereich (101, 111) mit einem Metallkontakt (705, 715) kontaktiert ist.

18. Halbleiteranordnung nach Anspruch 17, bei der der Metallkontakt (705, 715) mit dem leitfähigen Substratbereich (300) über den zweiten Halbleiterbereich (101, 111) und den Leiter (700, 713) ohmsch verbunden ist.
